Europäisches Patentamt

European Patent Office

Office européen des brevets

(19)

(11) Veröffentlichungsnummer: **0 340 603**
**A2**

## (12) EUROPÄISCHE PATENTANMELDUNG

(21) Anmeldenummer: 89107427.0

(51) Int. Cl.⁴: **G03G 13/01**

(22) Anmeldetag: **25.04.89**

(30) Priorität: **06.05.88 DE 3815538**

(43) Veröffentlichungstag der Anmeldung:
**08.11.89 Patentblatt 89/45**

(84) Benannte Vertragsstaaten:
**DE FR GB**

(71) Anmelder: **HOECHST AKTIENGESELLSCHAFT**
**Postfach 80 03 20**
**D-6230 Frankfurt am Main 80(DE)**

(72) Erfinder: **Winkelmann, Detlef, Dr.**
**Weinfeldstrasse 17**
**D-6200 Wiesbaden(DE)**

(54) **Verfahren zum Herstellen von Farbbildern.**

(57) Die Erfindung betrifft ein Verfahren zum Herstellen von Farbbildern auf elektrophotographischem Wege mittels Tonerbildübertragung, bei dem man nacheinander verschiedenfarbige Tonerbilder auf ein und dieselbe 4 - 40 μm dicke Klebeschicht aus einer druckempfindlichen Klebemasse, einem Haftkleber oder einem Schmelzkleber unter Anwendung von Druck überträgt.

Mit Hilfe des Verfahrens können originalgetreue Wiedergaben farbiger Vorlagen, insbesondere Farbbilder für Filmprüfverfahren, hergestellt werden.

EP 0 340 603 A2

## Verfahren zum Herstellen von Farbbildern

Die Erfindung betrifft ein Verfahren zum Herstellen von Farbbildern auf elektrophotographischem Wege mittels Tonerbildübertragung. Unter Farbbildern sollen allgemein mehrfarbige Darstellungen verstanden werden, besonders aber die originalgetreue Wiedergabe farbiger Vorlagen. Hierzu gehören vor allem auch Farbbilder für Farbprüfverfahren.

Farbprüfverfahren bzw. Farbprüfsysteme sind ein Hilfsmittel beim Farbdruck. Der Farbdruck ist dabei in der Regel als Vierfarbdruck zu verstehen. Sie werden an verschiedenen Stellen des Herstellungsprozesses eines Farbdruckes eingesetzt: zur Überprüfung der reproduktionsphotographischen Schritte bei der Herstellung der Farbauszugsfilme, als Muster oder Abstimmungsunterlage für den Auftraggeber des Farbdruckes und als Orientierungsmittel für den Drucker an der Druckmaschine.

Farbprüfsysteme werden hauptsächlich beim Tiefdruck und Offsetdruck eingesetzt, in geringem Umfang auch beim Flexodruck. Sie arbeiten mit den gerasterten Farbauszügen des farbigen Originals, wie sie zum Herstellen von Druckplatten der einzelnen Farben benötigt werden.

Bekannt sind hauptsächlich photochemisch arbeitende Farbprüfverfahren. Das derzeit am weitesten verbreitete System benutzt ein Laminat, bei dem klebrige Monomere bildmäßig photopolymerisiert werden und damit ihre Klebekraft verlieren. An den klebrig gebliebenen Bereichen haften trockene Farbpigmente. Für jede Farbe wird ein Laminatfilm aufgebracht, belichtet und betonert. Bei anderen Laminatverfahren werden UV-lichtempfindliche, gefärbte Schichten auf ein Trägermaterial übertragen, dort belichtet und an den Nichtbildstellen bzw. je nach Prozeß, an den Bildstellen, entschichtet. Auch gibt es photochemisch arbeitende Overlay-Systeme, bei denen UV-lichtempfindliche Farbfolien nach Kontaktbelichtung mit den Farbauszügen und nach der Entschichtung der bildfreien Stellen transparent werden. Passergenau übereinandergelegt, ergeben sie einen visuellen Eindruck der Farbvorlage.

Auch die Elektrophotographie wird zur Herstellung von Farbbildern eingesetzt. Im Vordergrund stehen dabei zumeist Farbkopierer, bei denen jedoch an die Echtheit der Farbwiedergabe und an den Grad der Bildauflösung nicht die hohen Ansprüche von Farbprüfverfahren gestellt werden. Dabei werden bevorzugt Trockentonerentwickler eingesetzt. Seit einiger Zeit werden aber auch elektrophotographisch arbeitende Farbprüfsysteme angeboten und eingesetzt. Diese verwenden Flüssigentwickler. Die bisher bekanntgewordenen elektrophotographischen Farbprüfverfahren arbeiten konventionell mit Überlagerung der Tonerbilder der einzelnen Farbauszüge. Dies geschieht entweder über einen Zwischenträger oder direkt auf der Photoleiterschicht. Bekannt ist auch, sämtliche Farbaus züge auf eine Photoleiterschicht übereinander zu kopieren und von dieser auf das endgültige Empfangsmaterial abzuklatschen. Bekannt sind auch elektrophotographisch arbeitende Systeme, bei denen die Belichtung des Photoleiters mittels eines digital, im Takt der Bildinformation gesteuerten Lasers geschieht.

Flüssigentwickler werden bei den bisher bekanntgewordenen elektrophotographisch arbeitenden Farbprüfsystemen deshalb verwandt, weil ihre Tonerteilchen eine geringe Partikelgröße haben, die in der Regel unter 1 μm liegt. Dadurch wird ein sehr hohes Auflösungsvermögen erreicht. Dem steht allerdings als Nachteil entgegen, daß ein isolierendes Dispersionsmittel, in der Regel ein verzweigter flüssiger Kohlenwasserstoff, eingesetzt werden muß, dessen Verdunstung Umweltprobleme mit sich bringt. Auch kommt die große mögliche Auflösung des Flüssigentwicklers dann nicht zum Tragen, wenn andere Prozeßschritte, wie die Abbildung selbst oder die Übertragung des Toners von geringerer Qualität sind. Häufig ist auch eine große Auflösung nicht erforderlich, bei der man Teilchen unter 1 μm haben müßte. Dies ist insbesondere dann der Fall, wenn die für den Farbdruck bestimmten Druckplatten nicht durch Kontaktkopie mit Filmvorlagen, sondern direkt von einer opaken Vorlage durch optische Abbildung über eine Linse erzeugt werden. Dies gilt zum Beispiel bei der Herstellung von Zeitun-gen, wo man in kurzer Zeit eine größere Zahl von Platten fertigen muß. Dabei arbeitet man maximal mit 48er Rastern (48 Bildelemente pro cm).

In der Regel ist jedoch das Raster deutlich gröber. Wegen der starken Zunahme der farbigen Bilder in Zeitungen stellt sich hier die Frage nach einem adäquaten Farbprüfsystem besonders. Auch beim Plakatdruck, bei dem Farbwiedergabe vorherrscht, ist eine Tendenz zur filmlosen Plattenherstellung zu beobachten. Hier ist das Raster noch wesentlich gröber, die Formate aber sind sehr groß.

Ein für diese Anwenderkreise geeignetes Farbprüfsystem muß schnell, zuverlässig und preiswert sein, aber auch die Verarbeitung sehr großer Formate ermöglichen. Die Auflösung hingegen muß nicht unbedingt höchsten Anforderungen genügen. Die Eigenschaftsprofile der üblichen elektrophotographischen Tonerbildübertragungsverfahren entsprechen diesen Forderungen nicht.

Wird Toner von der Photoleiterschicht auf ein Empfangsmaterial oder auf einen Zwischenträger und von diesem auf das Empfangsmaterial übertragen, so muß das bei Farbbildern passergenau geschehen, damit der richtige Farbeindruck entsteht. Auch müssen definierte Tonermengen übertragen werden, da andernfalls

2

die Tiefe der entsprechenden Farben nicht stimmt. Bei der üblichen elektrostatischen Übertragung beeinflußt, besonders bei Verwendung von Trockenentwicklern, der bereits übertragene Toner die Übertragung des darauffolgenden Toners.

Als wirkungsvolles und gleichmäßig arbeitendes Übertragungsprinzip ist bekannt, ein flächiges Material mit klebender Oberfläche in Kontakt mit dem sich auf der Photoleiterschicht befindlichen Tonerbild zu bringen. Da die Nichtbildstellen dann nach wie vor klebrig sind, ist die so gewonnene Kopie nur beschränkt verwendungsfähig. Bekannt ist die Variante, das Tonerbild auf dem Zwischenträger zu erhitzen und den Toner im Schmelzzustand dann auf das endgültige Empfangsmaterial zu übertragen. An den Zwischenträger wird dabei die Forderung gestellt, daß er mit dem Toner in eine nur möglichst geringe Wechselwirkung tritt, damit der Prozeß ohne Störung wiederholbar wird. Der Toner darf sich also insbesondere nicht oberflächlich in den Zwischenträger eindrücken.

Weiterhin ist es bekannt, Tonerbilder von Trockenentwicklern durch Druck in das Empfangsmaterial zu pressen. Dies geschieht hauptsächlich mit Einkomponenten-Magnetmaterialien und mit Zinkoxidpapieren. Dieses Verfahren hat jedoch wegen der relativ geringen Kopienqualität an Bedeutung verloren.

Aufgabe der Erfindung war es, auf Basis der Elektrophotographie ein Verfahren zu schaffen, mit dem man Farbbilder, insbesondere Vierfarbbilder, herstellen kann, insbesondere solche mit originalgetreuer Wiedergabe einer farbigen Vorlage, welches die Verwendung von Trockenentwickler gestattet, mit dem man auch große Formate bebildern kann und das in seiner Qualität insbesondere den Erfordernissen des Zeitungs- und Plakatdruckes angepaßt ist.

Diese Aufgabe wird bei dem erfindungsgemäßen Verfahren zur Herstellung von Farbbildern auf · elektrophotographischem Wege mittels Tonerübertragung dadurch gelöst, daß man nacheinander verschiedenfarbige Tonerbilder auf ein und dieselbe Klebeschicht unter Anwendung von Druck überträgt. Als Klebeschicht wird eine solche verwendet, die aus einer druckempfindlichen Klebemasse, einem Haftkleber oder einem Schmelzkleber besteht.

Bei dem erfindungsgemäßen Verfahren werden die einfarbigen Teilkomponenten einer farbigen Vorlage in aufeinanderfolgenden jeweils gleichen Zyklen auf einer geladenen Photoleiterschicht abgebildet und die entstandenen Ladungsbilder mit Toner in den entsprechenden Farben entwickelt und woraufhin Tonerbilder passergenau auf ein flächiges Empfangsmaterial übertragen werden. Die farbigen Tonerbilder werden nacheinander unter Druck auf ein flächiges Empfangsmaterial abgeklatscht, das eine Klebeschicht trägt.

In der Regel geht man von Vierfarbbildern aus, d.h. es liegen die Farbauszüge Gelb, Cyan, Magenta und Schwarz vor.

Vollständig übertragen werden vier getrennte Farbtonbilder dann, wenn der Übertragungsdruck hoch genug ist und wenn die Klebrigkeits- und Fließeigenschaften der aufnehmenden Klebeschicht dem Druck angepaßt sind.

Für die Festlegung der Bedingungen für die Übertragung muß man berücksichtigen: Eine die Photoleiteroberfläche deckende Schicht aus Trockentoner hat ein Flächengewicht von bis zu 5 g/m². Bei üblichem Trockentoner sind dies, in Abhängigkeit von der Partikelgröße des Toners, 1 bis maximal 3 Lagen des unfixierten Toners. Dieser fließt beim Fixieren auf eine geschlossene Schicht von etwa 5 $\mu$m zusammen. Es ist naheliegend, daß eine Klebeschicht von etwa gleicher Dicke das Vierfache an Toner nur dann aufnehmen kann, wenn sie extrem klebrig und fließfähig ist bzw. wenn ihre Komponenten in der Lage sind, den eingepreßten Toner von sich aus klebrig zu machen. Eine Klebeschicht von etwa 20 $\mu$m Dicke hingegen kann deutlich weniger klebrig und fließfähig sein, um etwa die gleiche Tonermenge aufzunehmen. In dem Bereich zwischen etwa 15 und 30 $\mu$m liegt demgemäß die bevorzugte Schichtdicke der Klebeschicht bei dem Verfahren mit vierfachem Toneranteil. Kleinere und größere Schichtendicken können ebenfalls eingesetzt werden, jedoch ist z.B. die obere Grenze abhängig davon, wie ähnlich der Proof dem tatsächlichen Vierfarbdruck sein soll. Erfindungsgemäß wird eine Klebeschicht verwendet, die eine Dicke von 4 bis 40 $\mu$m aufweist.

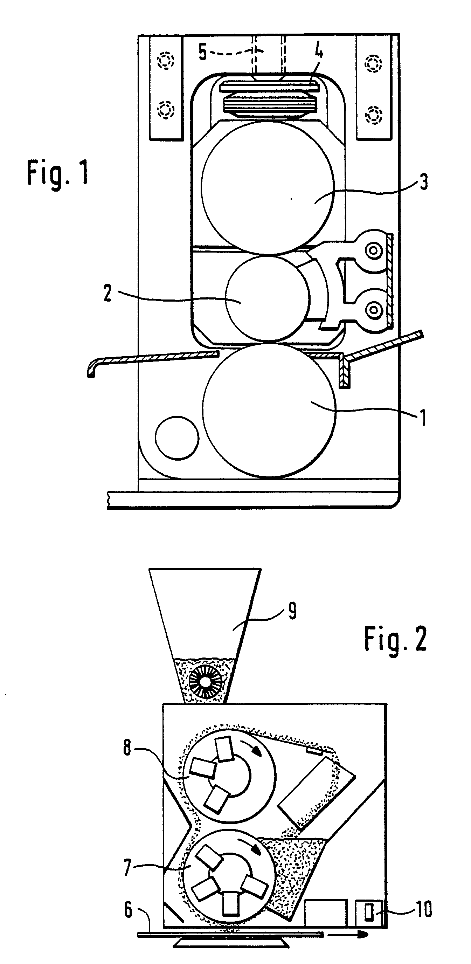

Hinsichtlich der Anpassung des Übertragungsdruckes und der Schichteigenschaften ist weiterhin zu berücksichtigen, daß die zur mehrfachen Tonerübertragung benutzten Vorrichtungen praxisgerecht sein müssen, insbesondere im Hinblick auf Größe und Gewicht. Eine bevorzugte Form, den Druck zwischen tonerbildtragender Photoleiterschicht und aufnehmender Klebeschicht aufzubringen, ist, das Schichtpaket durch ein unter Pressung stehendes Walzenpaar zu führen. Da es schwierig ist, die Fläche im Walzenspalt, auf die die Kraft wirkt, exakt zu bestimmen, wird die auf die Länge wirkende Kraft angegeben. Für Breiten bis zu 30 cm (Schmalseite DIN A3) sind von elektrophotographischen Bürokopierern her bekannte handelsübliche Druckwalzenfixiergeräte einsetzbar. Diese sind aufgebaut aus zwei oder drei unter Federdruck stehenden Walzen von einem Durchmesser bis zu 100 mm. Die beigefügte Figur 1 zeigt als Beispiel im Schnitt eine Dreiwalzendruckfixier-Vorrichtung. Mit dieser kann ein Liniendruck bis zu etwa 400 N/cm aufgebaut werden. Das Schichtpaket passiert den Spalt zwischen den Walzen 1 und 2. Walze 1 ist fest, die Walzen 2 und 3 hingegen sind beweglich angeordnet. Sie werden durch die Kraft der Feder 4 auf die Walze 1 gedrückt. Die Feder wiederum kann mit dem Bolzen 5 eingestellt werden. Die Vorrichtung hat eine Masse von etwa 10 kg. Zu größeren Arbeitsbreiten hin jedoch müßten die Walzen dicker werden und es würde die Masse überproportional ansteigen und bei einer Arbeitsbreite von etwa 1000 mm rund 100 kg betragen. Überdies besteht bei großen Formaten und hohem Liniendruck die Gefahr des Faltenwurfs. Für Formate mit einer Schmalseite von 1000 mm und mehr werden daher zur Ausführung des Verfahrens Vorrichtungen bevorzugt, die einen niedrigeren Lininendruck aufbringen. Vom mechannischen Aufbau her ist zum Beispiel eine Vorrichtung geeignet, wie sie in DE-AS 27 29 523, entsprechend US-PS 4,155,637, für einen anderen Zweck beschrieben ist. Sie kommt mit relativ dünnen und entsprechend leichteren Walzen aus. Deren Durchbiegung wird kompensiert durch an definierten Stellen angebrachte Stützwalzen und durch eine sich über die ganze Breite erstreckende und unter Andruck stehende Lamelle. Es läßt sich damit ein Liniendruck von 20 N/cm erreichen. Entsprechend dem niedrigeren Druck muß die Klebrigkeit und Weichheit des Empfangsmaterials bei Verwendung einer solchen Vorrichtung deutlich größer sein als im erstbeschriebenen Fall der stärker drückenden Walzen. Es wird dann nicht mehr der gesamte Toner von der Photoleiterschicht übertragen. Es wird vielmehr nur die obere Tonerlage abgenommen, was jedoch die Durchführbarkeit des Verfahrens nicht mindert. Die Photoleiterschicht muß dann, soll sie wiederverwendet werden, durch Reinigen vom restlichen Toner befreit werden.

Bei dem erfindungsgemäßen Verfahren wird zur Tonerbildübertragung vom Photoleiter auf die Klebeschicht ein Walzenpaar verwendet, das einen Liniendruck im Bereich von etwa 10 N/cm bis 200 N/cm ausübt. Eine Variante des erfindungsgemäßen Verfahrens ist, mit nur geringem Druck eine Lage des Tonerbildes abzunehmen und in einem zweiten Schritt unter größerem Druck den Toner in die Klebeschicht einzudrücken. Dies ist besonders dann von Vorteil, wenn die Photoleiterschicht mehrmals verwendet werden soll. Anderenfalls besteht die Gefahr, daß bei hohem Liniendruck die Photoleiterschicht und deren Schichtträger beschädigt werden.

Je nachdem, unter welchem Druck die Tonerbilder übertragen werden und wie klebrig und dick die Aufnahmeschicht ist, ist das mehrfarbige Tonerbild wischfest oder es kreidet ab. Ist es wischfest so ist mitunter die Schicht an den bildfreien Stellen noch klebrig. Das durch mehrfache Tonerübertragung auf eine Klebeschicht erhaltene Farbbild ist daher in der Regel nicht die endgültige Form. Diese entsteht erst durch weitere Verfahrensschritte. Letztere wiederum hängen davon ab, ob man ein opakes oder ein transparentes Trägermaterial als endgültiges Empfangsmaterial für das herzustellende Farbbild verwendet.

Wird opakes Material als Schichtträger für die Klebeschicht und die darauf gebrachten Toner eingesetzt, so ist das Bild nur in Draufsicht zu betrachten. Damit es seitenrichtig ist, muß das Original auf der Photoleiterschicht spiegelbildlich abgebildet werden. Sofern das Bild noch abkreidet oder klebt, kann in bekannter Weise ein Sprühlack zum Abdecken aufgebracht werden. Vorzuziehen ist hingegen, eine dünne, transparente Schicht mittels einer Folie aufzubringen. Sie kann aus einem dünnen, transparenten Träger mit einer dünnen Klebeschicht bestehen oder die Schicht auf der Folie kann in bekannter Weise photochemisch reaktiv sein, so daß man sie nach dem Auflaminieren einer UV-Belichtung aussetzen muß und man dann den transparenten Träger abziehen kann.

Bevorzugt ist aber, auf der Photoleiterschicht die Farbauszüge seitenrichtig abzubilden, so daß auf dem endgültigen Empfangsmaterial das Farbbild seitenverkehrt ist. Dieses ist dann durch eine transparente Trägerschicht hindurch zu betrachten oder aber es wird auf ein endgültiges Empfangsmaterial übertragen, auf dem man das Bild dann in Aufsicht seitenrichtig sieht.

Ist der Schichtträger der Klebeschichten transparent und sind diese sehr klebrig, so können Schichtträger und Klebeschicht mit dem Bild auf ein anderes flächiges Material geklebt werden. Reicht die verbleibende Klebrigkeit der das Tonerbild tragenden Klebeschichten nicht aus, kann das gegengedrückte Material ebenfalls eine Klebeschicht tragen. Dieses flächige Material kann opak oder transparent sein. Eine vorteilhafte Verfahrensvariante ist, die Tatsache auszunutzen, daß mit steigender Temperatur die Haftkraft der Klebeschicht zunimmt. Die das mehrfarbige Tonerbild tragende Klebeschicht kann daher, insbesondere wenn ein Schmelzkleber verwendet wird, durch Wärme auf das flächige endgültige Empfangsmaterial gebügelt werden. In der Regel wird dabei der Toner geschmolzen, so daß dessen Haftkraft ebenfalls zum Tragen kommt. Mischen sich Klebeschicht und Toner im geschmolzenen Zustand, so wird das mehrfarbige Tonerbild transparent. Auf einem ebenfalls transparenten Gegenmaterial entsteht so ein durchsichtiges Farbbild.

Eine besonders günstige und daher auch bevorzugte Verfahrensweise ist, das farbige Tonerbild mitsamt der Klebeschicht thermisch auf das flächige endgültige Empfangsmaterial zu übertragen und den ursprünglichen Träger der Klebeschicht abzuziehen. Dazu darf die Haftung zwischen Klebeschicht und Träger nicht zu hoch sein. Diese läßt sich jedoch nach dem Stand der Technik durch Aufbringen einer Release-Schicht direkt auf den Träger den Erfordernissen anpassen. Beim Abklatschen kommt die klebrige

4

Aufnahmeschicht nach oben. Ihre Klebrigkeit muß dementsprechend wieder beseitigt werden, damit das Bild grifffest wird. Um dies zu erreichen, kann die Klebeschicht aus zwei Lagen bestehen, wobei die nach der Übertragung auf das endgültige Empfangsmaterial außenliegende Schicht die innere auf dem ursprünglichen Träger ist und diese ein Schmelzkleber ist, der bei Zimmertemperatur nicht klebt. Beide Schichten zusammen sollen möglichst nicht dicker als 20 μm sein, damit der Charakter des Aufnahmematerials, also des Auflagenpapiers, möglichst wenig verändert wird. Dieses Ziel läßt sich auch erreichen, indem man die Klebeschicht photochemisch reaktiv ausstattet. Bekannte Formulierungen, wie sie zum Beispiel von Flexodruckschichten oder Trockenresists her bekannt sind, können verwendet werden. Nach dem Laminieren der tonerbildtragenden Klebeschicht unter Wärme auf das endgültige Empfangsmaterial wird durch den transparenten Träger hindurch die photochemische Klebeschicht mit UV-Licht ausgehärtet, und danach wird die Trägerschicht abgezogen.

Eine weitere Möglichkeit besteht darin, eine photochemisch reaktive Klebeschicht nach dem Aufnehmen des Toners, aber vor dessen Übertragung, soweit durchzuhärten und zu vernetzen, daß deren Erweichungs- und Schmelzbereich deutlich über dem des Toners liegt. Beim Aufpressen unter Wärme wird dann nicht mehr die gesamte Schicht übertragen, sondern nur noch der Toner geschmolzen und auf das endgültige Empfangsmaterial gebracht.

Als Klebeschichten sind dementsprechend vorteilhaft verwendbar, solche, die einen mehrlagigen Aufbau mit mindestens einer stärker und mindestens einer weniger stark klebenden Schicht aufweisen, wobei bei mehrlagigem Aufbau die mit dem Schichtträger in Kontakt befindliche Lage weniger klebrig ist. Es kann auch vorteilhaft sein eine mehrlagige Klebeschicht zu verwenden, deren oberste Lage so wenig klebrig ist, daß sie griffest ist. Vorteilhaft ist auch eine Klebeschicht, die photochemisch reaktiv ist oder die durch Photopolymerisation nachhärtbar ist.

Für die den Toner aufnehmende Klebeschicht steht eine breite Palette geeigneter Substanzen zur Verfügung. In der Regel bestehen diese aus einem Polymeren, das die Kohäsionseigenschaften bestimmt, und klebrigmachenden Harzen. Dabei können die Harze ganz oder teilweise durch ungesättigte Monomere ersetzt sein, die sich ihrerseits wieder polymerisieren lassen.

Relativ wenig klebend, dafür aber ohne Abdeckschicht verwendbar und leicht handhabbar sind Klebeschichten aus druckempfindlicher Klebemasse, wie sie bei sogenannten druckempfindlichen Klebebändern eingesetzt werden. Diese haben den Vorteil, daß sie sich von Photoleiterschichten rückstandsfrei wieder abziehen lassen, so daß keine zusätzliche Releaseschicht auf dem Photoleiter erforderlich ist. Die Klebemassen bestehen in der Regel aus 65 - 75 Gewichtsteilen Kautschuk und Harz, 1 - 2 Gewichtsteilen Alterungsschutzmittel und 10 - 20 Gewichtsteilen an Weichmachern. Die hier üblichen Füllstoffe können nur dann in inkorporiert werden, wenn die Klebeschicht das endgültige Empfangsmaterial darstellt und das Farbbild in Aufsicht betrachtet wird. Natur- und Synthesekautschuktypen können eingesetzt werden. Die klebrigmachende Harzkomponente kann aus Kolophonium oder seinen Estern bestehen. Polyterpenharze werden wegen ihrer Oxidationsbeständigkeit bevorzugt. Auch Kohlenwasserstoffharze sowie Cumaron-, Inden- und Phenolformaldehydharze sind einsetzbar. Der Erweichungspunkt und die eingesetzte Menge des Harzes sind eine wesentliche Komponente zur Beeinflußung der Klebrigkeit.

Auch dauerklebrige Haftkleber, wie sie auf Haftetiketten oder selbstklebenden Dekorfolien verwendet werden, sind für das erfindungsgemäße Verfahren geeignet. Als Rohstoffe dienen natürliche und synthetische Kautschukarten in Verbindung mit modifizierten Natur-, Phenolformaldehyd- oder Kohlenwasserstoffharzen. Neben Kautschuk werden häufig auch Polyacrylsäureester, Polymethacrylsäureester, Polyvinylether und Polyisobutentypen oder auch deren Copolymerisate verwendet. Die Klebemassen werden in Form von Lösungen auf Papier oder Folie aufgebracht. Das Lösemittel wird dann entfernt. Auch Dispersionsklebstoffe können eingesetzt werden. Diese bestehen vornehmlich aus Polyacrylsäureestern bzw. Vinylacetatcopolymerisaten. Die Haftklebeschichten müssen bis zur Anwendung mit geeigneten abhäsiv ausgerüsteten Materialien, wie zum Beispiel Silikonpapier oder silikonisierter Polyethylenfolie, abgedeckt werden.

Für die vorstehend erwähnte besonders bevorzugte Ausführungsform des erfindungsgemäßen Verfahrens, bei dem als mehrlagige Klebeschicht eine doppellagige Klebeschicht aus einem stärker und einem weniger klebenden, griffesten Material besteht, sind Schmelzkleber besonders geeignet. Viele der heute angebotenen Schmelzkleber sind Mischungen von etwa gleichen Teilen Ethylen-Vinylacetatcopolymerisaten, die unterschiedliche Gehalte an Vinylacetat und damit variierende Schmelzindices besitzen, mit Balsamharzen oder Kolophoniumderivaten, Kohlenwasserstoffharzen und Wachsen bzw. Paraffinen. Sie sind, soweit sie bei Zimmertemperatur eine gewisse Klebrigkeit zeigen, für das erfindungsgemäße Verfahren, in dünner Schicht angewendet, geeignet. Anstelle von Ethylen-Vinylacetatcopolymeren können auch niedermolekulare Polyethylene, ataktische Polypropylene und Ethylenacrylestercopolymerisate bzw. carboxylgruppenhaltige Copolymerisate sowie Styrol-Butadien und Styrol-Isopren-Blockcopolymerisate eingesetzt werden. Auch Schichten, die Polyamide, Polyaminoamide sowie aliphatische und aromatische Polyester oder schmelzbare Polyurethane enthalten, sind grundsätzlich für das erfindungsgemäße Verfahren geeignet.

Als Schichtträger für die Klebeschicht wird, wie weiter unten noch näher ausgeführt, Polyesterfolie, bevorzugt biaxial verstreckte Polyesterfolie, eingesetzt. Dies ist dann von Vorteil, wenn die Klebemasse einen Schmelzbereich unter etwa 130 °C hat. Beim Schmelzübertrag schrumpft der Schichtträger nicht, und die Maßgenauigkeit bleibt gesichert. Werden zweilagige Klebeschichten aufgebracht, so muß die direkt im Kontakt mit dem Folienträger bzw. mit einer Release-Schicht auf der Folie härter und griffester eingestellt sein als die äußere Klebeschicht, die den Toner aufnimmt. Letztere sollte aus einem oberflächenklebrigen Schmelzklebstoff bestehen. Eine geeignete Auswahl ist bei dem großen Angebot von Schmelzklebern nicht schwierig.

Photochemisch reaktive Massen, aus denen Klebeschichten für das erfindungsgemäße Verfahren hergestellt werden können, sind hingegen nicht unmittelbar am Markt erhältlich. Bekannte Formulierungen können jedoch angepaßt werden. Photopolymerschichten enthalten mindestens vier Substanzgruppen: Bindemittel, Monomer, Photoinitiator und Stabilisator. Durch Art und Gehalt von Bindemittel und Monomer werden Klebrigkeit und thermisches Verhalten beeinflußt. Bevorzugt für die erfindungsgemäße Verwendung sind als Bindemittel thermoplastische Elastomere, wobei Styrol-Butadien und Styrol-Isopren-Blockcopolymerisation im Vordergrund stehen. Als additionspolymerisierbare, ethylenisch ungesättigte Monomere sind Trimethylolpropantrimethacrylat, Hexandioldiacrylat und Hexandioldimethacrylat bevorzugt. Als Photoinitiatoren dienen Ketone wie Ethylanthrachinon oder Michler's Keton. Phenole wie 2,6-Di-tert-butyl-4-methylphenol oder p-Methoxyphenol dienen als Stabilisatoren. Schichten in Stärken von 5 - 50 $\mu$m können z.B. durch Beschichten aus einer 50 % igen Lösung in Toluol durch Abdunsten des Toluols oder durch Schmelzextrusion aus einer Breitschlitzdüse gewonnen werden. Eine dünne Poylethylen- oder Polypropylenfolie gegen die vorzeitige Reaktion mit Sauerstoff sind erforderlich.

Auch photopolymerisierbare Massen, bei denen das Bindemittel keine gummielastische Komponente hat, sind für das erfindungsgemäße Verfahren einsetzbar. Materialien, wie sie in der Reprographie z.B. zur photomechanischen Herstellung von Druckformen oder Leiterplatten dienen, können modifiziert eingesetzt werden. Deren Fähigkeit zur bildmäßigen Differenzierung sowie die dabei resultierenden Löslichkeitsunterschiede sind zwar für das erfindungsgemäße Verfahren nicht unmittelbar von Bedeutung, können aber für Verfahrensvarianten genutzt werden. Lichtempfindliche Gemische dieser Art enthalten mindestens eine polymerisierbare Verbindung, mindestens einen Photoinitiator und mindestens ein Mischpolymerisat mit mindestens einer ungesättigten Carbonsäure. Photopolymerisierbare Monomere sind z.B. Acryl- und Methacrylsäureester wie Diglycerindiacrylat, Polyethylenglykoldimethacrylat, Acrylate und Methacrylate von Trimethylolethan, Trimethylolpropan und Pentaerythrit und mehrwertigen alicyclischen Alkoholen. Besonders vorteilhaft werden Umsetzungsprodukte von Diisocyanaten mit Partialestern mehrwertiger Alkohole eingesetzt. Als Photoinitiatoren eignen sich eine Vielzahl von Substanzen, beispielsweise Benzoine und Mehrkernchinone. Das Mischpolymerisat besteht bevorzugt aus einem Terpolymerisat aus Methacrylsäure, Methyl- oder Ethylmethacrylat und einem Alkylmethacrylat mit 4 - 15 Kohlenwasserstoffatomen in der Alkylgruppe. Durch das Monomer-Bindemittel-Verhältnis sowie Zusammensetzung und Polymerisationsgrad des Polymeren lassen sich Klebrigkeit und Viskosität der Schichten in weiten Grenzen variieren. Die Schichten werden aus Lösemitteln direkt auf den Polyesterschichtträger gebracht und das Lösemittel wird abgedampft.

An die Maßgenauigkeit werden bei Farbprüfsystemen hohe Anforderungen gestellt. So muß die Abweichung der Kopie in der Länge vom Original kleiner als 1 mm pro Meter sein. Papiere müssen hochfest sein und sollten ein Flächengewicht von 200 g/m² nicht unterschreiten. Papiere sind jedoch nur unter konstanten Klimabedingungen zu verwenden, da deren Längenausdehnung bzw. Schrumpf bei stark schwankender Luftfeuchte größer als der angegebene Wert ist. Bevorzugt werden daher transparente Folien eingesetzt. Wegen der Beanspruchung während des Übertragens im Walzenspalt dürfen diese aus nur wenig verformbaren Materialien bestehen. Auch ist, sofern das Bild durch die Folie hindurch betrachtet werden soll, optisch einwandfreie Qualität erforderlich. Biaxial verstreckte Polyesterfolien erfüllen diese Forderungen und werden bevorzugt verwendet. Sie werden je nach Größe des Formates und des Anwendungszwecks, in Dicken von 50 - 180 $\mu$m im erfindungsgemäßen Verfahren eingesetzt. Auch Polycarbonatfolien sind geeignet.

In der Regel können die Klebeschichten ohne Zwischenschicht auf den Schichtträger aufgebracht werden. In einzelnen Fällen ist es jedoch zweckmäßig, eine Haft-oder Trennschicht zu verwenden. Hafvermittelnde Schichten bestehen bevorzugt aus Natur- oder Synthesekautschuken mit einem Flächengewicht von bis zu 1 g/m². Sie sind besonders bei weichen Schichten vorteilhaft, da andernfalls durch die tangentialen Kräfte bei der Übertragung eine Dehnung des Klebefilms auf dem Schichtträger stattfinden kann, ohne daß dieser mitgedehnt wird. Das Farbbild wird so in einer Richtung gelängt. Die Passergenauigkeit wäre damit für die folgenden Übertragungsschritte nicht mehr gegeben. Als Release-Schicht werden

6

Silikone, insbesondere Polydibutylsiloxan und Polytetrafluorethylen sowie Carbamidharze eingesetzt. Eine Release-Schicht empfiehlt sich, wenn die Verfahrensvariante des Schmelzübertrages eines thermoplastischen Elastomeren vorgesehen ist.

Bei der Auswahl von Photoleitern für die Verwendung im erfindungsgemäßen Verfahren ist man nicht beschränkt auf einen Typ. Schichten aus Selen und seinen Legierungen, aus amorphem Silizium, aus Zinkoxid/Bindemittel sowie organische Photoleiterschichten können im Prinzip in gleicher Weise eingesetzt werden. Zu berücksichtigen ist, daß die den Toner aufnehmende Klebeschicht nicht untrennbar auf dem Photoleiter haften darf und daß, soll der Photoleiter mehrmals verwendet werden, dieser nicht durch den Druck bei der Übertragung beschädigt wird.

Bei anorganischen Photoleiterschichten ergibt sich aus der Chemie heraus nur wenig Möglichkeit, durch die Schichtzusammensetzung die Haftung wesentlich zu verändern. Durch vorzugsweises Aufbringen einer dünnen, haftungsreduzierenden Deckschicht in einer Dicke bis zu 1 $\mu$m kann man diesem Mangel abhelfen, ohne die sonstigen elektrophotographischen Eigenschaften wesentlich zu verändern. Allerdings ist in der Regel die Lebensdauer der Deckschicht nicht so hoch wie die des Photoleiters, so daß sich die Antihafteigenschaften während der Benutzung vermindern. Bei Zinkoxid-Bindemittelschichten besteht da dadurch, daß man als Polymerkomponente teilweise oder ganz Silikonharze einsetzen kann, die Möglichkeit, eine gegen die meisten Klebstoffe ausreichend abhäsive Wirkung zu erreichen.

Die größte Variationsbreite hinsichtlich der Anpassung der Oberflächeneigenschaften bieten organische Photoleiterschichten, die daher auch bevorzugt eingesetzt werden. Zu unterscheiden ist zwischen Schichten, bei denen die Prozesse der Ladungsträgererzeugung und des Ladungsträgertransportes in einer homogenen Schicht vor sich gehen oder ob sie in getrennten Schichten stattfinden.

Homogene Schichten bestehen aus einer festen Lösung des eigentlich monomeren Photoleiters in einem polymeren Bindemittel. Als Photoleiter kommen z.B. in Frage 2,5-Bis-4'-dimethylaminophenyl-1,3,4-oxdiazol, 1,2-Aryl- und 2-Alkylderivate des Bis-5,2'-chlorphenyl-4,4'-diethylaminophenyloxazols oder 2,4'-Diethylaminophenyl-6-methylbenzdiazols. Bindemittel können z.B. sein: Copolymerisate aus Acrylaten und Methacrylaten und Styrol, aber auch Copolymerisate des Vinylchlorids z.B. mit Maleinsäureanhydrid. Der Photoleiteranteil in den amorphen Schichten kann bis zu maximal 50 Gewichtsprozent betragen, liegt in der Regel jedoch zwischen 25 und 30 Gewichtsprozent.

Da die Absorption der meisten monomeren, organischen Photoleiter im nahen UV liegt, ist es erforderlich, die Schichten für das sichtbare Licht zu sensibilisieren. Dies gelingt leicht mit den auch aus der Silberhalogenid photographie bekannten Sensibilisatoren wie z.B. Astrazon Orange R (C.I. 48 040) oder Brillantgrün (C.I. 42 040). Die erforderliche Menge des Sensibilisators liegt in der Regel unter 1 Gewichtsprozent der Gesamttrockenmasse.

Photoleiterschichten, bei denen die Funktion der Ladungsträgererzeugung und des Ladungsträgertransportes getrennt sind, bestehen in der Regel aus einem Pigment, in dem sich nach Lichtabsorption Ladungsträger bilden und einer Transportschicht, die aus einem photoleitenden Polymeren oder einem Polymeren mit einem darin gelösten photoleitenden Monomeren besteht. Die Pigmente können entweder in der Schicht dispergiert sein oder eine getrennte Lage bilden. Vertreter mehrerer Pigmentklassen sind als Photoleiter bekannt. Besonders zu erwähnen sind Perylimidderivate wie z.B. das N,N'-Dimethylperylimid oder das N,N'-Dimethoxypropylperylimid, Perinone wie Orange GR oder Phthalocyanine wie $\epsilon$-Kupferphthalocyanin. Häufig werden auch Bisazopigmente wie Dianablau oder Chlordianablau eingesetzt. Als Transportmedium für die Ladung werden die bei den vorstehend erwähnten homogenen Schichten genannten Photoleiter und Bindemittel verwendet. Ist das Pigment in der Schicht dispergiert, so kann sein Anteil bis zu 60 Gewichtsprozent betragen. Der Anteil an monomerem Photoleiter kann relativ gering sein und etwa 5 Gewichtsprozent der Gesamttrockenmasse betragen. Die Gesamtschichtdicken von pigmentierten organischen Photoleitern liegen zwischen 3 $\mu$m und 20 $\mu$m. Sind ladungsträgererzeugendes Medium und Ladungsträgertransport in getrennten Schichten angeordnet, so hat die Ladungsträgererzeugungsschicht in der Regel eine Dicke von etwa 1 $\mu$m, die Transportschicht hat typischerweise eine Dicke zwischen 4 und 20 $\mu$m.

Als Schichtträger für die Photoleiterschichten kommen Trommeln aus Metall oder flächige ebene Materialien, die zumindest eine elektrisch leitende Oberfläche haben, in Frage. Trommeln werden eingesetzt, wenn der Photoleiter wiederholt verwendet werden soll. Es empfiehlt sich dann allerdings, den Übertragungsschritt nicht im oberen angegebenen Druckbereich, sondern eher im unteren durchzuführen. Andernfalls besteht die Gefahr einer Beschädigung des Photoleiters bei mehrfacher Nutzung. Für die flächige Ausführungsform werden bevorzugt Aluminiumfolien und -platten eingesetzt. Ihre Dicken können im Bereich von weniger als 1 $\mu$m bis zu 400 $\mu$m liegen. Im unteren Bereich werden mit Aluminium bedampfte oder besputterte Folien, insbesondere Polyesterfolien eingesetzt, im mittleren von etwa 10 - 50 $\mu$m auf Kunststoff-Folie oder Papier laminierte Aluminium-Folien und im oberen Dickenbereich freitragende Platten.

7

Vorteilhaft werden diese noch an der Oberfläche behandelt, z.B. durch leichtes Aufrauhen und/oder Anodisieren. Dadurch wird eine Verbesserung der Haftung erreicht. Da bei hohem Übertragungsdruck im erfindungsgemäßen Verfahren dünne Aluminiumplatten verformt werden, empfiehlt sich deren Einsatz nur, wenn das Schichtträgermaterial und die Photoleiterschicht so preiswert sind, daß für jede Farbe des Auszuges eine eigene Platte verwendet werden kann. Aluminiumkaschiertes Papier erfüllt diese Bedingungen. Ein besonders preiswertes Material ergibt sich, wenn eine homogen sensibilisierte oder eine pigmentdispergierte Photoleiterschicht in einer Dicke von weniger als 5 μm auf aluminiumkaschiertes Papier gebracht wird.

Das erfindungsgemäße Verfahren zum Herstellen von Farbbildern ist auf die Verwendung von Trockenentwicklern, d.h. Trockentonern hin beschrieben. Im Prinzip ist jedoch auch Flüssigtoner, d.h. Flüssigentwickler, einsetzbar, wenn bestimmte Bedingungen erfüllt sind. So darf der abgeschiedene Toner nicht koagulieren und einen geschlossenen Film bilden, da dieser nach der Übertragung die Klebkraft der dann darunter befindlichen Aufnahmeschicht mindert oder wegnimmt. Auch sollen die dispergierten Partikel nicht oder nur wenig im Dispersionsmittel quellen, da sie sich dann nur schlecht in die Klebeschicht eindrücken lassen. Wegen des Verlustes von Dipsersionsmittel durch Verdunsten müssen umweltschützende Maßnahmen bedacht werden.

Trockenentwickler werden in Form von Ein- oder Zweikomponentenentwicklern eingesetzt. Magnetische Einkomponentenentwickler sind für Farbbilder nur beschränkt verwendbar, da die eingearbeitete ferromagnetische Komponente eine Eigenfärbung hat. Nicht magnetische Einkomponentenentwickler, die triboelektrisch aufgeladen werden, sind im Prinzip einsetzbar, sind jedoch wegen der schwer einzuhaltenden Aufladungskonstanz für anspruchsvolle Arbeiten aber weniger geeignet. Bevorzugt sind Zweikomponentenentwickler, die aus ferromagnetischen, grobteiligen Trägerteilchen und feinteiligen Toner teilchen bestehen. Tonerteilchen, wie sie in elektrophotographischen Bürokopierern verwendet werden, haben, ob schwarz oder farbig, in der Regel einen mittleren Teilchendurchmesser um 10 μm. Bei Farbprüfsystemen ist es aber üblich, 10 μm breite einzelstehende Linien sauber wiederzugeben. Dies ist mit Teilchen, die einen Durchmesser von 10 μm haben, nicht zu erreichen. Für die Anwendung im erfindungsgemäßen Verfahren müssen die Tonerteilchen daher einen kleineren Durchmesser haben. Optimale, für die Praxis ausreichene Ergebnisse werden erhalten, wenn der Mittelwert des Teilchendurchmessers zwischen 3 und 5 μm liegt. Mit modernen Mahl- und Sichtanlagen ist dies erreichbar. Wegen des größeren Oberfläche/Masseverhältnisses im Vergleich zu üblichen gröberen Tonern muß in der Regel der Zusatz von Steuermittel niedriger bemessen sein als bei gröberen Tonern. Die triboelektrische Aufladung des Toners auf einen richtigen Wert einzustellen und ihn dort während der Benutzung zu halten, ist bei Farbtonern ein wichtiges Kennzeichen, da die Farbdichte, welche von der Menge des abgeschiedenen Toners abhängt, einen zusätzlichen Informationsinhalt darstellt. Die spezifische Ladung der Farbtoner liegt zwischen 15 und 50 μC/g, bevorzugt zwischen 20 und 30 μC/g. Geringere Werte führen zu stärkerer Tonerabscheidung, können aber auch bewirken, daß Nichtbildbereiche leicht einfärbbar werden. Ist die Aufladung höher, wird die Abscheidung geringer, feine Bildelemente werden spitzer. Dies ist in gewissem Umfang tolerierbar, da man diesem Effekt durch höhere Aufladung und geringere Belichtung der Photoleiterschicht entgegenwirken kann.

Trockentoner für Zweikomponentenentwickler bestehen aus einem polymeren Bindemittel, einer oder mehreren färbenden Komponenten und in der Regel einem oder mehreren Ladungssteuermitteln. Sämtliche Komponenten haben Einfluß auf die Aufladbarkeit des Toners und müssen daher bei Farbtonern besonders sorgfältig ausgewählt werden.

Die Schmelz- und Fließeigenschaften des Toners beim Fixieren sind im wesentlichen durch die thermischen Eigenschaften des polymeren Bindemittels gegeben. Je nach Fixierart sind Polymerzusammensetzung und Molekulargewicht unterschiedlich. Bei Bürokopierern hat sich die Heißwalzenfixierung weitgehend durchgesetzt. Bei dieser taucht das Problem des sogenannten kalten und heißen Offsets auf. Im Bereich des ersten Schmelzens wird der Toner klebrig und neigt zum Haften an der Fixierwalze (kalter Offset), bei hohen Fixiertemperaturen wird er dünnflüssig und es sinkt seine Kohäsion und Oberflächenspannung, so daß wiederum Benetzen der Walze eintreten kann. Um diesen Verfahrensparameter möglichst breit zu halten, werden Polymerisate spezieller Zusammensetzung, insbesondere definierten Molekulargewichts und definierter Molekulargewichtsverteilung eingesetzt. Diese sind häufig durch eine starke Uneinheitlichkeit gekennzeichnet, die in vielen Fällen sogar 2 Maxima der Molekulargewichtsverteilung haben. So hat z.B. ein besonders günstiges und häufig eingesetztes Polymerisat ein $M_w$ von 133.000 und ein $M_n$ von 13.500, wobei ein erstes Molekulargewichtsmaximum bei 20.000 und ein zweites bei 400.000 liegt. Bindemittel dieser Art sind auch im erfindungsgemäßen Verfahren einsetzbar, besonders, wenn die Variante des Schmelzübertrages angewendet wird.

Bekannte Bindemittel für Trockentoner sind z.B. Styrolacrylat-Copolymerisate, Styrolacrylnitril-Copolymerisate oder Styrolbutadien-Copolymerisate. Eingesetzt werden auch Epoxiharze vom Bisphenoltyp. Gute Gebrauchseigenschaften weisen auch Polyesterharze auf. Der Erweichungspunkt der Tonerpolymeren liegt üblicherweise zwischen 110 und 180 °C. Erwünscht ist, daß die Glasumwandlungstemperatur 50 - 80 °C beträgt. Liegt sie niedriger, so kann der Toner backen, ist sie höher, liegt meist die Fixiertemperatur zu hoch.

Die triboelektrischen Eigenschaften der meisten zur Tonerherstellung geeigneten Polymeren sind nicht sehr ausgeprägt. Mehrheitlich beobachtet man bei zu Tonergröße zerkleinertern Polymerisaten ohne weitere Zusätze in Kombination mit den handelsüblichen Trägerteilchen eine schwache negative Aufladung. Durch Einbau funktioneller Gruppen wie -COOH oder -NH$_2$, wie sie zum Beispiel in US-PS 3,985,664 und US-PS 4,049,477 beschrieben sind, kann die Aufladung gezielt eingestellt werden.

Farbpigmente, wie sie als Farbmittel für Toner eingesetzt und auch im erfindungsgemäßen Verfahren benutzt werden, zeigen von sich aus fast immer einen triboelektrischen Effekt. Als Regel gilt, daß Substanzen mit NR$_3$ bzw. NR$_4^+$-Gruppen positiv und solche mit z.B. COOH, SO$_3$H, CONR$_2$ und SO$_2$NR$_2$-Gruppen negativ steuern. Eine weitere Regel ist, daß Substanzen mit Elektronenakzeptoreigenschaften potentiell negative und solche mit Donatoreigenschaften potentiell positive Steuermittel darstellen. In Kombination mit den vorerwähnten Tonerpolymeren ändern sich die triboelektrischen Eigenschaften. Häufig beobachtet man, daß ein in das Polymere inkorporiertes Pigment seine Ladungstendenz nicht durchsetzen kann. Mitunter jedoch ist ein sehr starker Einfluß vorhanden. Daraus folgert, daß bei der Auswahl von Farbmitteln für Farbtoner nicht nur die koloristischen Aspekte berücksichtigt werden müssen, sondern auch deren triboelektronischer Einfluß auf dem Tonerteilchen.

Geeignete Pigmente für Farbtoner finden sich unter den bekannten Farbstoffgruppen der Dioxazine, der Phthalocyanine, der Perylene, der Chinacridone, der Azopigmente und der verlackten Azopigmente. Vertreter der Nigrosine, der Triphenylmethanfärbmittel, der kationischen Farbmittel und der Chromkomplexe kommen gegebenenfalls als Zusätze bei der Anpassung von Farbton und Steuerung in Frage.

Beispiele für Farbmittel sind organische chromhaltige Verbindungen wie Acetoessigsäure-Monoazogelbpigmente auf Arylamidbase (fast yellow Serie, z.B. CI-Pigmentgelb 1, 3, 74, 97 und 98), Acetoessigsäure-Diazogelbpigmente auf Arylamidbasis (wie z.B. CI-Pigmentgelb 12, 13 und 14), gelbe Farbstoffe (wie z.B. CI-Lösungsmittelgelb 12, 19, 77 und 79 und CI-Dispersgelb 164), rote oder scharlachrote Pigmente (wie z.B. CI-Pigmentrot 48, 49, 1.53, 1.57, 57, 1, 81, 122 und 5), Farben auf Rotbasis (wie z.B. CI-Lösungsrot 49, 52, 58 und 8), Pigmente auf Blaubasis (wie Kupferphthalocyanin und dessen Derivate (wie z.B. CI-Pigmentblau 15:3) und Grünpigmente wie CI-Pigmentgrün 7 und 36). C.I. bedeutet die Constitution Number, die im Color-Index, 3. Auflage (1971, London) zur Identifizierung der Farbstoffe verwendet wird.

Eine Verschärfung der Anfoderungen im Hinblick auf die richtige Auswahl der Pigmente ergibt sich dadurch, daß Farbprüfverfahren zu einem vom Druck möglichst nicht unterscheidbaren Farbbild führen sollen. Da die Farborte für Farbdrucke eng festgelegt sind (Normfarben gemäß Eurostandard) und bestimmte handelsübliche Pigmente diesen Anforderungen genügen, liegt es nahe, aus deren Palette für die Verwendung in elektrophotographischen Tonern geeignete herauszusuchen und die Toner mit diesen zu optimieren. Als geeignet befunden wurden: für Gelb: Permanentgelb DHG (CI-Pigment Yellow 12), Permanentgelb GR (CI-Pigment Yellow 13), Mischungen aus Permanentgelb GG 02 (PY 17) und Novothermgelb HR (PY 83). Diese Diazopigmente bringen eine stark negative triboelektrische Komponente mit sich. Für Cyan: aus der Gruppe der Phthalocyanine Hostaperm Blau B2G und Hostaperm Blau B3G. Auch diese Pigmente haben eine negativ steuernde Wirkung. Für Magenta: Permanentrubin L6B (CI 15850:1), Permanentrubin F6B (PR 184), Mischungen aus Hostaperm Rosa E (PR 122) und Permanentcarmin FBB02 (PR 146). Permanentrubin 6B bringt eine negativ steuernde Komponente ein, die anderen Pigmente steuern positiv. Für die Schwarzkomponente werden übliche Toner eingesetzt, bei denen Ruß und Nigrosin die Färbung ergeben.

Bei dem feinteiligen Toner, wie er bevorzugt im erfindungsgemäßen Verfahren verwendet wird, muß ein entsprechender Träger eingesetzt werden. Im Prinzip können sämtliche der für diesen Zweck technisch eingesetzten Produkte wie Eisen-, Mangan-, Nickel-, Kobalt- oder Chrompulver oder solche aus Eisenlegierungen oder aus ferromagnetischen Oxiden wie Ferriten und Magnetiten eingesetzt werden. Deren Oberfläche soll möglichst groß sein. Dies ist bei zerklüfteten schwammigen oder plättchenförmigen Strukturen gegeben. Besonders geeignet sind RZ-Späne (Mannesmann AG), die durch Versprühen von flüssigem Eisen und schnellem Abschrecken entstehen. Bei diesen ist sichergestellt, daß Toner in einer Konzentration bis zu etwa 5 Gewichtsprozent, bezogen auf den Träger, keine mehrlagigen Schichten auf dem Träger bildet, da dies zu ungleichmäßiger und unzureichender Aufladung des Toners führt. Die Teilchendurchmesser des Trägermaterials liegen etwa zwischen 70 und 200 µm.

Eine wichtige Komponente im Trockenentwickler ist das Steuermittel für den Toner, welches zum Einstellen der triboelektrischen Aufladbarkeit dient. Bei üblichen Schwarztonern werden für diesen Zweck bevorzugt Nigrosintypen eingesetzt. Da diese aber selbst dunkel gefärbt sind, scheiden sie als Steuermittel für Farbtoner aus. Farblose positive Aufladung bewirkende Steuermittel sind unter den organischen polyvalenten Metallverbindungen zu finden. Kalziumstearat und Zinkstearat sowie Natriumoleat sind als typische Vertreter zu nennen. Wirksam sind auch Zinksalze von Polycarbonsäuren. Diese sind sehr schlagzäh und daher nur schwer in andere Polymerisate einzuarbeiten. Sie machen den Toner härter, so daß er bei der Übertragung leichter in die Klebemasse dringt. Farblose, für Farbtoner geeignete Steuermittel auf der Basis organischer Borverbindungen werden in DE-OS 37 07 303, entsprechend GB-PS 2,189,036, beschrieben.

Das erfindungsgemäße Verfahren zum Herstellen von Farbbildern besteht aus folgenden Schritten:

Erzeugen eines latenten Ladungsbildes vom Farbauszug (dieser ist in der Regel gerastert) einer Farbvorlage,

Entwickeln des Ladungsbildes mit einem Toner in der korrespondierenden Farbe,

Übertragen des Tonerbildes unter Aufdruck auf eine flächige Klebeschicht und

Wiederholen dieser Schritte mit den weiteren Farbauszügen.

Die Klebeschicht mit den Tonern kann dann, wie vorstehend detailliert dargestellt, nach unterschiedlichen Methoden weiterverarbeitet werden.

Das elektronische Aufladen und Belichten geschieht nach dem bekannten Stand der Technik und kann in für diesen Zweck bekannten Vorrichtungen vorgenommen werden. Wegen der erforderlichen Genauigkeit werden bevorzugt solche Vorrichtungen eingesetzt, wie sie zum Herstellen von Offsetdruckplatten auf elektrophotographischem Wege bekannt sind. Diese arbeiten entweder mit optischer Abbildung über eine Linse oder mit scannender Laserbelichtung. Die darin zu verarbeitenden Photoleiterschichten sind entweder organischer Natur oder bestehen aus Zinkoxid in einem Bindemittel. Die Schichtträger bestehen zumeist aus Aluminium in Blechform. Auch aluminiumkaschiertes Papier ist brauchbar.

In den zur Herstellung von Offsetdruckplatten auf elektrophotographischem Wege verwendeten Reprokameras herrschen in der Abbildungsebene Intensitäten von einigen $\mu W/cm^2$. Da die Photoleiterschichten der vorerwähnten Art zwischen 10 und 30 $\mu J/cm^2$ zum Ausbelichten erfordern, ergeben sich Belichtungszeiten zwischen 10 und 30 sec zum Erzeugen eines latenten Ladungsbildes. Unter Berücksichtigung der erforderlichen Transportschritte und des Entwicklungsprozesses kann man auf diese Weise pro Minute 1 - 2 Platten herstellen. Bei einem Vierfarbenauszug kann somit bei Verwendung einer solchen Kamera alle 2 - 4 Minuten ein komplettes Farbbild entstehen. Dies ist eine kürzere Zeit als die bei den konventionellen photochemisch arbeitenden Verfahren übliche.

Es ist auch möglich, transparente Farbauszüge durch Kontaktbelichten auf der Photoleiterschicht abzubilden. Die Belichtungszeiten werden dann noch kürzer. Der Gesamtprozeß läßt sich jedoch dadurch nicht wesentlich beschleunigen, da die weiteren Prozeßschritte kaum ohne Qualitätsverlust schneller als oben durchgeführt werden können.

Die bildmäßige Belichtung kann auch vorteilhaft in einem Laserbelichtungsgerät durchgeführt werden, wie es in der EP-A 0 000 048, entsprechend US-PS 4,149,798, beschrieben ist. Dieses arbeitet mit einem 16 mW Argonionenlaser bei einer Wellenlänge von 488 nm.

Beim Entwickeln der einzelnen Ladungsbilder mit den korrespondierenden Farbtonern wird vorteilhaft die bekannte Magnetbürstenentwicklung angewendet. Diese garantiert hohe Bildschärfe, gleichmäßige Tonerabscheidung und hohe Konstanz. Besonders vorteilhaft wird dazu eine Entwicklereinheit eingesetzt, wie sie in DE-OS 26 58 792 beschrieben und in Figur 2 schematisch dargestellt ist. Bei dieser wird der Entwickler von oben der zu entwickelnden ladungsbildertragenden ebenen Photoleiterschicht angeboten. Diese ist in Figur 2 durch Ziffer 6 gekennzeichnet. Element 7 stellt die Magnetwalze dar, mit der der Entwickler angetragen wird. Die darüberliegende Walze 8 dient zum Transport des Entwicklers nach oben, damit dieser Fallhöhe zum Mischen bekommt. Darüber sitzt eine Nachdosiereinheit 9, auf der entsprechend zum Tonerverbrauch frischer Toner nachdosiert werden kann. Eventuell mit der Platte herausgetragener ferromagnetischer Träger wird durch eine Magnetleiste 10 abgenommen.

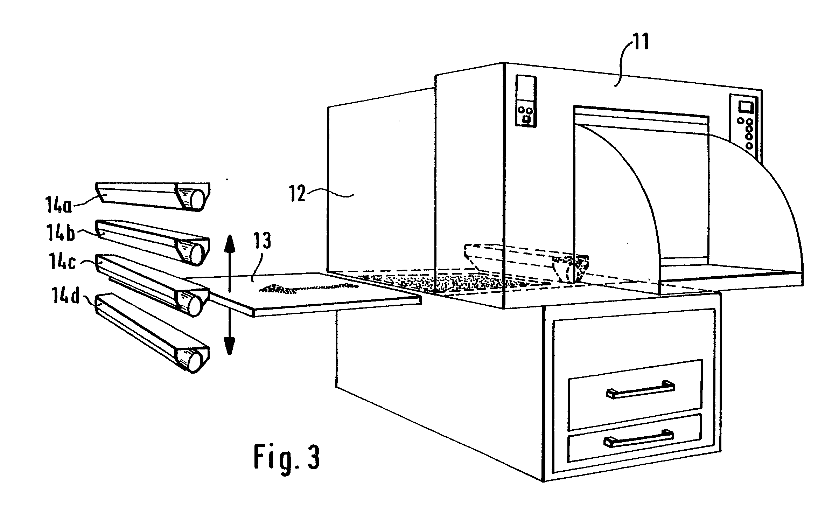

Entwicklungsgeschwindigkeiten von 0,5 - 5 m/min sind möglich. Durch den kompakten Aufbau der Vorrichtung sind Entwicklungsbreiten bis zu 1 m realisierbar. Für jede Farbe ist eine Entwicklereinheit vorgesehen. Diese können dicht hintereinander oder übereinander angeordnet sein. Es muß dann, je nach Farbauszug, die korrespondierende Entwicklereinheit in Kontakt mit der das latente Ladungsbild tragenden Photoleiterschicht gebracht werden. Eine bevorzugte Ausführungsform, bei der die einzelnen Entwicklereinheiten übereinander angeordnet sind, zeigt Figur 3. Auf dieser sind Kamera- und Entwicklungsteil eines handelsüblichen Automaten zum Verarbeiten elektrophotographischer Flachdruckplatten dargestellt. In der Baueinheit 11 befinden sich Auflade- und Optikteil, mit denen das latente Ladungsbild hergestellt wird. Die Platte wandert dann in das Bauelement 12, in dem normalerweise mit schwarzem Toner entwickelt wird. Die Platte fährt dann in das Fixierungs- und Entwicklungsteil. Um Farbauszugsbilder herzustellen, wird die noch nicht entwickelte Platte mit dem latenten Ladungsbild auf den Hebetisch 13 geschoben. Dieser bewegt sich

10

dann vor das entsprechende Entwicklerteil (14a, 14b, 14c oder 14d) und die Platte wird unter diesem hindurchgeführt. Der Übersicht halber ist das Gehäuse nicht dargestellt.

Bei den vorhergehenden Überlegungen war stets davon ausgegangen worden, daß positive Farbauszüge vorliegen, die auch positiv entwickelt werden sollen. Häufig liegt jedoch der Fall vor, daß negative Vorlagen zu positiven Farbbildern zu verarbeiten sind. Auch dies ist nach dem erfindungsgemäßen Verfahren möglich. Ist z.B. die Schicht negativ geladen, scheidet sich positiv geladener Toner an den Bildstellen ab. Um an den Nichtbildstellen keinen Toner abzuscheiden, liegt eine Spannung an der Magnetbürste (Gegenspannung), die etwas höher ist als die Restspannung des latenten Bildes. Um relativ gleiche Potential verhältnisse bei umgekehrten hell/dunkel Bedingungen zu erhalten, wird die Platte positiv aufgeladen. Wird die Magnetbürste auf eine dem Bildstellenpotential entsprechende positive Spannung gebracht, so werden mit positiv geladenem Toner die entladenen Flächen betonert. Die geladenen Bildbereiche hingegen nehmen wegen der Gleichheit des Potentials mit der Bürste keinen Toner an. Bei Verwendung von negativ geladenem Toner sind die Polaritäten entsprechend umgekehrt anzuwenden.

Um die nötige Passerung zwischen klebrigem Empfangsmaterial und der das Tonerbild tragenden Photoleiterschicht zu erreichen, wird wie folgt verfahren: Die erste Übertragung wird ohne exakte Passerung vorgenommen. Die auf jedem Farbauszug vorhandenen Passerkreuze werden mitkopiert. In das Empfangsmaterial werden dann direkt auf den übertragenen Passerkreuzen oder in definiertem Abstand Löcher gestanzt. In gleicher Weise wird weiterverfahren, dann jedoch werden die Passerlöcher direkt in die Platten gestanzt, die die weiteren Tonerbilder der Farbauszüge tragen. Die Löcher vom Empfangsmaterial und jeweils die Löcher in den einzelnen Platten werden dann durch Stifte übereinander gebracht. So kann man opake wie transparente Materialien gleichermaßen passergerecht verarbeiten. Wird ein transparenter Schichtträger für die Klebeschicht eingesetzt, besteht grundsätzlich auch die Möglichkeit, die Passerkreuze visuell aufeinander zu bringen. Da der Toner aber noch nicht wischfest und die Aufnahmeschicht klebrig ist, ist so die Passerung in der Regel schwieriger zu bewerkstelligen als bei Verwendung von Stiften.

Bei sehr großen Formaten empfiehlt es sich, Passerlöcher nicht nur auf der Vorderkante, sondern auch an einer Seitenkante, allerdings nicht zu weit von der Vorderkante entfernt, anzubringen.

Bei einer anderen Ausführungsform des Verfahrens wird das Empfangsmaterial sogleich gelocht und auf Stiften an eine Trommel gehängt. Diese hat zweckmäßigerweise den Umfang der Länge des Aufnahmebogens. Die Platte mit dem Tonerbild kann dann wie bei einer Druckmaschine auf den Gegenzylinder gespannt werden. In diesem Falle muß, ebenfalls wie beim Druck, sichergestellt werden, daß die Befestigungslöcher in definiertem Abstand zu den Passerkreuzen liegen. Da die erwähnten Kameras in ihrer Präzision auf die Herstellung von Mehrfarbenplatten eingerichtet und die Platten selbst exakt rechtwinklig geschnitten sind, ist diese Forderung erfüllbar.

Das Schichtpaket aus betonertem Photoleiter (mit Schichtträger) und Klebeschicht (mit Schichtträger) wird dann in den Walzenspalt der weiter oben beschriebenen Druckübertragungsvorrichtung geführt. Es ist zweckmäßig, für das Schichtpaket eine Einführplatte mit Anlegekante zu verwenden und dem eigentlichen Druckwalzenpaar ein Walzenpaar vorzuordnen aus weichem Material, mit dem das Schichtpaket geführt wird. Auch ist es vorteilhaft, das Druckwalzenpaar erst dann zu schließen, wenn die Anfangskante des Schichtpakets eingelaufen ist.

Als abschließender Schritt wird bevorzugt das Tonerbild zusammen mit der Klebeschicht, aber ohne dessen Schichtträgermaterial, auf das endgültige Empfangsmaterial übertragen. Dies ist in der Regel das Auflagenpapier des Druckproduktes, welches simuliert werden soll. Die Übertragung geschieht bevorzugt durch Wärme mit einer Klebeschicht, die, wie weiter oben beschrieben, Heißsiegeleigenschaften haben muß. Für diesen Zweck ist eine Vielzahl von Geräten einsetzbar, die sonst zum Laminieren und Kaschieren von heißsiegelfähigen Klebefolien dienen. Bevorzugt werden Geräte eingesetzt, die zum Auflaminieren von Photoresistschichten auf Leiterplatten dienen, da diese wegen Hochwertigkeit der darauf verarbeiteten Produkte eine einwandfreie Bahnführung haben und eine gute Temperaturkonstanz aufweisen. Vorteilhaft wird die Arbeitstemperatur unter 125 °C gehalten. Bei dieser Temperatur zeigt die bevorzugt als Träger angewandte Polyesterfolie noch kein Schrumpfverhalten. Die vorerwähnten Kaschiervorrichtungen sind auch darauf eingerichtet, eine abgezogene Folie aufzuwickeln. Dies kann im Falle des erfindungsgemäßen Verfahrens die Folie sein, die ursprünglich die Klebeschicht getragen hat oder die Trägerfolie einer Abdeckschicht. Der bei Verwendung einer photopolymerisierbaren Schicht erforderliche Flutbelichtungsschritt kann mit UV Lichtquellen durchgeführt werden, wie sie in der Reprographie zum Belichten von Druckplatten oder Lichtpauspapieren üblich sind.

Die Erfindung wird anhand der folgenden Beispiele näher beschrieben, ohne sie hierauf zu beschränken.

Beispiel 1

Es wurde eine Photoleiterschicht folgender Zusammensetzung hergestellt:

| 100 Gt | (Gewichtsteile) eines Mischpolymerisates aus n-Hexylmethacrylat, Styrol, Methacrylsäure und Acrylsäure (42:12:21:25 Molprozent), |
| 80 Gt | 2,5-Bis(4'-diethylaminophenyl)-oxdiazol-1,3,4, |
| 1 Gt | Astrazon Orange G (CI 48035), |
| 0,1 Gt | Rhodamin FB (CI 45170). |

Die Dicke der Photoleiterschicht betrug 4 μm, als Schichtträger diente eine anodisierte Aluminiumplatte von 100 μm Dicke.

Ein Satz aus vier farbigen Tonern wurde wie folgt hergestellt: Es wurde ein Polymerisat aus 70 Gewichtsprozent Styrol und 30 Gewichtsprozent Butylmethacrylat mit einem Molekulargewicht von 30.000 eingesetzt. Jeweils 90 Gt davon wurden getrennt mit jeweils 10 Gt Permanentgelb GG, Hostaperm Rosa E, Hostaperm Blau BL2G sowie in jedem Fall zusätzlich 1 Gewichtsprozent Natriumoleat gemischt und extrudiert. Für den Schwarztoner wurden 90 Gt des Polymeren mit 10 Gt Ruß Raven 1020 sowie 2,5 Gt Nigrosin gemischt und extrudiert. Die Tonerschmelzen wurden in üblicher Weise gebrochen, gemahlen und extrudiert. In allen vier Fällen wurde der Mittelwert des Tonerteilchendurchmessers auf 4 μm eingestellt. Als Tonerträger wurden RZ-Späne im Teilchenbereich von 80 bis 100 μm eingesetzt. Der Toneranteil wurde in jedem Fall auf 3 Gewichtsprozent eingestellt.

Als klebendes Aufnahmematerial wurde eine 170 μm klare Polyesterfolie, auf der sich eine 10 μm dicke Schicht eines Gemisches aus 60 Gt Polyterpenharz mit 40 Gt Hypalon(R) (chlorsulfoniertes Polyethylen) befand, verwendet.

Zum Aufladen, Belichten und Entwickeln der Photoleiterschicht wurde eine elektrophotographische Kamera des Typs EA 692 (Hersteller Hoechst AG) eingesetzt. Als Vorlage diente ein vierteiliger Satz einer vierfarbigen Testvorlage. Die Photoleiterschicht wurde auf - 400 V geladen und dann 20 Sekunden lang belichtet. Für die Entwicklung in den einzelnen Farben wurde jeweils das mechanische Entwicklerteil angesteuert mit dem Toner der entsprechenden Farbe, wie es schematisch in Figur 3 gezeigt ist. Der so erhaltene Satz von 4 Platten mit den verschiedenfarbigen Trockentonerbildern wurde nacheinander auf die mit Klebeschicht versehene Polyesterfolie übertragen. Dies geschah in der Folge Schwarz, Cyan, Magenta und Gelb. Eingesetzt wurde dazu eine Walzenfixiervorrichtung der Firma Hitachi von 30 cm Arbeitsbreite. Der Druck wurde auf 100 N/cm eingestellt. Die Tonerübertragung war in allen Fällen 100%ig. Die Durchlaufgeschwindigkeit betrug 2 m/min.

Der übertragene Toner kreidete nur wenig, die Schicht war fast klebfrei. Um eine Aufsichtsvorlage zu erhalten, wurde dann das Tonerbild auf ein Papier gewalzt, das seinerseits mit der gleichen Klebeschicht wie das Aufnahmematerial versehen worden war.

Die so erhaltene Vierfarbenkopie ist bis zum 40er Raster einwandfrei abgebildet. Ihre Farbwiedergabe entspricht weitgehend dem Original.

Beispiel 2

Um aus einem Farbauszugssatz von Negativ-Vorlagen eine Positiv-Farbkopie zu erhalten, wurde wie im Beispiel 1 verfahren, mit dem Unterschied, daß die Schicht nicht negativ, sondern positiv auf 350 V geladen wurde.

Während der Entwicklung wurde an die Magnetbürste eine Spannung von + 200 V gelegt.

Die erhaltene Farbkopie war in ihrer Wiedergabequalität vergleichbar mit der, die mit dem entsprechenden Satz Positiv-Vorlagen hergestellt wurde.

Beispiel 3

Als Photoleiterschicht wurde eine Pigmentdispersionsschicht eingesetzt. Diese besteht aus 62 Gewichtsprozent Orange GR (CI 71105, Pigmentorange 43, VAT Orange 7, CAS 4424-06-0), 33 Gewichtsprozent eines Polymeren aus 60 Gewichtsprozent n-Hexylmethacrylat, 35 Gewichtsprozent Methacrylsäure und

EP 0 340 603 A2

5 Gewichtsprozent Styrol sowie 5 Gewichtsprozent 2,5-Bis(4'-diethylaminophenyl)-1,3,4-oxdiazol. Das Schichtgewicht wurde auf 5 g/m² eingestellt.

Für den Farbtonersatz wurde als Bindemittel ein nichtlineares Polyesterharz verwendet. Dieses wurde gemäß Herstellungsbeispiel 1 der DE-OS 37 09 535 hergestellt. Das Harz hat eine Glasumwandlungstemperatur von 70 °C und einen Erweichungspunkt von 145 °C. Als Pigmente wurden Permanent Gelb GR, Permanent Karmin FB01 und Hostaperm Blau BL2G eingesetzt. Die färbende Komponente für den Schwarztoner war Ruß. Jeweils 5 Gewichtsprozent der genannten Pigmente wurden in das Harz eingearbeitet und daraus in bekannter Weise Toner hergestellt. Die Mittelwerte der Teilchendurchmesser wurden auf 5 µm gesichtet. Die Toner sind von sich aus negativ geladen und zeigen eine spezifische Ladung zwischen 15 und 35 µC/g, sofern 2 Gewichtsprozent davon mit einem Träger des RZ-Typs im Trockenentwickler gemischt werden.

Als klebendes Aufnahmematerial wurde eine photochemisch nachhärtbare Schicht eingesetzt. Diese bestand zu 85 Gewichtsprozent aus Cariflex TR 1107 (Blockcopolymerisat aus 15 % Styrol und 85 % Isopren), zu 10 Gewichtsprozent aus Hexandioldimethacrylat, zu 1,5 Gewichtsprozent aus Benzophenon und zu 0,5 Gewichtsprozent aus 4-Hydroxy-3,5-di-tert-butyltoluol. Die Klebeschicht wurde in einer Dicke von 30 µm aus einer 50%igen Lösung in Toluol auf 125 µm dicken Polyesterfilm gebracht.

Aufgeladen, belichtet und entwickelt wurde die Photoleiterschicht in einer Laserbelichtungsvorrichtung, wie sie in der EP-A 0 000 048 beschrieben ist. Als Original wurde ein Vierfarbauszug auf opakem Papier eingesetzt. Die einzelnen Farbauszüge wurden nacheinander linienförmig mit einem fokussierten Laserstrahl abgetastet. Dazu wurde ein 1 mW Helium/Neon-Laserstrahl eingesetzt. Belichtet wurde mit einem im Takt der Hell/Dunkel-Information des Leselasers modulierten 10 mW Argon/Ionen-Laser, der bei einer Wellenlänge von 488 nm emittiert. Die Scan-geschwindigkeit betrug 300 Linien/sec, die Scandichte 40 Linien/mm. Der Laserstrahl war sowohl beim Abtasten als auch beim Belichten auf 50 µm fokussiert. Die Lichtleistung des Argon/Ionen-Lasers auf der Platte wurde zu 650 µW bestimmt. Daraus ergibt sich eine Energieaufnahme der Photoleiterschicht von 11 bis 15 µJ/cm². Die Laserbelichtungsvorrichtung enthält integriert eine Entwicklereinheit, wie sie in Figur 2 gezeigt ist. Bei dieser wird das Entwicklergemisch der das latente Ladungsbild tragenden Photoleiterschicht von oben her angeboten. Die Vorschubgeschwindigkeit der Photoleiterplatte wurde auf 1,5 m/min eingestellt. Die Entwicklergemische in den einzelnen Farben wurden nacheinander in das mechanische Entwicklerteil gegeben.

Die Übertragung auf das klebrige Aufnahmematerial wurde, wie in Beispiel 1 beschrieben, durchgeführt.

Die vier Farben tragende Klebeschicht wurde dann bei 125 °C auf ein kalandriertes Papier von 100 g/m² Flächengewicht kaschiert. Durch die Folie hindurch wurde die Klebemasse für 1 Minute einer UV-Belichtung ausgesetzt. Danach konnte die Trägerschicht abgezogen werden.

Es resultierte ein mehrfarbiges Bild, auf dem auch kleinste Details einwandfrei erkennbar waren.


Beispiel 4

Es wurde eine zweilagige Photoleiterschicht eingesetzt. Diese enthielt als Schichtträger eine aluminiumbedampfte Polyesterfolie. Direkt darauf gebracht war eine 0,2 µm dicke Schicht aus N,N'-Dimethylperylimid und darauf eine 15 µm dicke Transportschicht, die zu 60 Gt aus 2,5-Bis(4'-diethylaminophenyl)-oxdiazol-1,3,4 und 40 Gt hochviskoser Nitrocellulose bestand. Diese Schicht wurde negativ aufgeladen.

Zur Entwicklung wurde der Vierfarbentonersatz des Beispiels 1 benutzt.

Die Klebeschicht bestand aus einer Mischung von 6,5 Gt eines Mischpolymerisates aus 30 Gt Methacrylsäure, 60 Gt n-Hexylmethacrylat und 10 Gt Styrol sowie 5,6 Gt eines Monomeren, das durch Umsetzen von 1 mol 2,2,4-Trimethylhexamethylendiisocyanat und 2 mol Hydroxyethylmethacrylat erhalten wurde und 1 Gt Triethylenglykoldimethacrylat, 0,2 Gt Michler's Keton und 0,2 Gt Benzophenon. Aufgebracht war die Masse in einer Dicke von 25 µm auf einer Polyesterfolie von 50 µm.

Die vier Farbauszüge, die Photoleiterfolie und das Aufnahmematerial wurden vor der weiteren Verarbeitung gemeinsam mit Passerlöchern versehen.

In einer Dunkelkammer wurde die Photoleiterschicht in einem Durchlaufaufladegerät auf - 400 V geladen. Belichtet wurde in einem mit entsprechenden Passerstiften versehenen Kopierrahmen. Die das latente Ladungsbild tragende Folie wurde dann auf eine ebene Fläche gelegt und dort angesaugt. Darüber fuhr dann eine Entwicklereinheit mit Tonerantrag von oben. Es wurde jeweils mit dem zum Auszug korrespondierenden Toner entwickelt. Danach wurde die Photoleiterfolie auf eine Trommel mit 2 Klemmleisten gespannt. Die Folie mit der Klebeschicht wird in gleicher Weise auf eine Gegendruckwalze gebracht. Die Walzen wurden dann synchron laufend aneinander gedrückt, wobei die Übertragung stattfand. Die Photoleiterschicht wurde daraufhin mit einer rotierenden Bürste von restlichem Toner befreit, und es wurde

EP 0 340 603 A2

wie beim ersten Schritt das nächste Bild darauf kopiert und weiterverarbeitet.

**Ansprüche**

1. Verfahren zum Herstellen von Farbbildern auf elektrophotographischem Wege mittels Tonerbildübertragung, dadurch gekennzeichnet, daß man nacheinander verschiedenfarbige Tonerbilder auf ein und dieselbe Klebeschicht unter Anwendung von Druck überträgt.

2. Verfahren nach Anspruch 1, dadurch gekennzeichnet, daß man eine Klebeschicht verwendet, die aus einer druckempfindlichen Klebemasse, einem Haftkleber oder einem Schmelzkleber besteht.

3. Verfahren nach den Ansprüchen 1 und 2, dadurch gekennzeichnet, daß man eine Klebeschicht verwendet, die eine Dicke von 4 - 40 μm aufweist.

4. Verfahren nach den Ansprüchen 1 bis 3, dadurch gekennzeichnet, daß man eine Klebeschicht verwendet, die einen mehrlagigen Aufbau mit mindestens einer stärker und mindestens einer weniger stark klebenden Schicht aufweist.

5. Verfahren nach den Ansprüchen 1 bis 4, dadurch gekennzeichnet, daß man eine mehrlagige Klebeschicht verwendet, deren mit dem Schichtträger in Kontakt befindliche Lage weniger klebrig ist.

6. Verfahren nach den Ansprüchen 1 bis 5, dadurch gekennzeichnet, daß man eine mehrlagige Klebeschicht verwendet, deren oberste Lage so wenig klebrig ist, daß sie griffest ist.

7. Verfahren nach den Ansprüchen 1 bis 6, dadurch gekennzeichnet, daß man eine Klebeschicht verwendet, die photochemisch reaktiv ist.

8. Verfahren nach den Ansprüchen 1 bis 7, dadurch gekennzeichnet, daß man eine Klebeschicht verwendet, die durch Photopolymerisation nachhärtbar ist.

9. Verfahren nach Anspruch 1, dadurch gekennzeichnet, daß man einen transparenten flächigen Schichtträger für die Klebeschicht verwendet.

10. Verfahren nach den Ansprüchen 1 und 9, dadurch gekennzeichnet, daß man ein Klebematerial verwendet, bei dem sich zwischen Schichtträger und Klebeschicht eine Releaseschicht befindet.

11. Verfahren nach den Ansprüchen 1, 9 und 10, dadurch gekennzeichnet, daß man eine Klebefolie verwendet, deren Schichtträger eine Polyesterfolie ist.

12. Verfahren nach Anspruch 1, dadurch gekennzeichnet, daß man zum Tonerbildübertrag vom Photoleiter auf die Klebeschicht ein Walzenpaar verwendet, das einen Liniendruck im Bereich von 10 N/cm bis 200 N/cm ausübt.

13. Verfahren nach Anspruch 1, dadurch gekennzeichnet, daß man die Klebeschicht zusammen mit den daran haftenden verschiedenfarbigen Tonern durch Wärme auf ein endgültiges Empfangsmaterial überträgt.

14. Verfahren nach den Ansprüchen 1, 7, 8 und 13, dadurch gekennzeichnet, daß man mit UV-Strahlung durchhärtet.

15. Verfahren nach den Ansprüchen 1, 13 und 14, dadurch gekennzeichnet, daß man die Trägerfolie der Klebeschicht vom Schichtpaket abzieht.

16. Verfahren nach Anspruch 1, dadurch gekennzeichnet, daß man die Photoleiterschicht bildmäßig mit den gerasterten Farbauszügen eines Farbbildes belichtet und daß man Toner verwendet, die zum Entwickeln der latenten Ladungsbilder in den Normfarben des Mehrfarbendruckes eingefärbt sind.

17. Verfahren nach den Ansprüchen 1, 13, 15 und 16, dadurch gekennzeichnet, daß man als endgültiges Empfangsmaterial das Auflagenpapier des Mehrfarbendruckes verwendet.

18. Verfahren nach Anspruch 1, dadurch gekennzeichnet, daß man einen Photoleiter einsetzt, der eine dünne haftungsreduzierende Deckschicht trägt.

14

Fig. 1

Fig. 2

Fig. 3

HOECHST AKTIENGESELLSCHAFT — 88/K 029

EP 0 340 603 A2